Europäisches Patentamt

European Patent Office

Office européen des brevets

(11) Numéro de publication: **0 084 475**
**A2**

## (12) DEMANDE DE BREVET EUROPEEN

(21) Numéro de dépôt: 83400037.4

(22) Date de dépôt: 07.01.83

(51) Int. Cl.³: **H 01 L 27/10**
**G 11 C 17/00, G 11 C 17/06**

(30) Priorité: 15.01.82 FR 8200613

(43) Date de publication de la demande:
27.07.83 Bulletin 83/30

(84) Etats contractants désignés:
CH DE FR GB IT LI NL

(71) Demandeur: THOMSON-CSF
173, Boulevard Haussmann
F-75379 Paris Cedex 08(FR)

(72) Inventeur: Terre, Jean-Luc
THOMSON-CSF SCPI 173, bld Haussmann
F-75379 Paris Cedex 08(FR)

(74) Mandataire: Guérin, Michel et al,
THOMSON-CSF SCPI 173, Bld Haussmann
F-75379 Paris Cédex 08(FR)

(54) Matrice d'éléments à mémoire intégrés, à diode Schottky sur silicium polycristallin, et procédé de fabrication.

(57) L'invention concerne une mémoire morte intégrée du type matrice à diodes dans laquelle le point d'intersection entre une ligne (14) et une colonne (20) est constitué soit par deux diodes Schottky en série tête-bêche (état logique 0), soit par une diode Schottky en série avec une résistance (état logique 1). Une diode Schottky est réalisée par du silicium polycristallin peu dopé (18) déposé sur du métal (14); l'autre diode Schottky est constituée par une couche de métal (20) déposée sur le silicium polycristallin (18). Cette deuxième diode Schottky est courtcircuitée en dopant la surface supérieure du silicium de manière à réaliser un contact ohmique (état logique 1).

Fig.1

Fig.2

EP 0 084 475 A2

Croydon Printing Company Ltd.

MATRICE D'ELEMENTS A MEMOIRE INTEGRES, A DIODE SCHOTTKY SUR
SILICIUM POLYCRISTALLIN, ET PROCEDE DE FABRICATION.

La présente invention concerne les circuits intégrés et notamment ceux qui comportent des mémoires mortes programmées par le constructeur.

On sait qu'on peut réaliser un réseau de points-mémoire discrets sous forme d'une matrice de diodes, en constituant un ensemble de lignes conductrices indépendantes et un ensemble de colonnes conductrices perpendiculaires aux lignes et en prévoyant à chaque point de croisement d'une ligne et d'une colonne une interconnexion entre la ligne et la colonne; cette interconnexion peut être soit une connexion de résistance infinie, c'est-à-dire pratiquement une absence de connexion, pour représenter un premier état d'un point-mémoire correspondant à ce croisement de ligne et de colonne, soit une diode pour représenter un second état du point-mémoire. L'application d'une tension correspondant à une polarisation directe de la diode entre une ligne et une colonne déterminée permet de déterminer immédiatement si une diode est absente (premier état du point mémoire) ou présente (deuxième état).

La présente invention s'inspire de ce type de mémoire morte et propose une mémoire en réseau de lignes et de colonnes dont les points de croisement sont interconnectés par une structure facilement réalisable en circuit intégré de très petites dimensions.

Dans cette structure, chaque point-mémoire, c'est-à-dire chaque interconnexion entre une ligne et une colonne conductrice est constituée soit par deux diodes Schottky en série tête-bêche (premier état du point mémoire), soit par une diode Schottky en série avec une résistance (deuxième état).

Selon l'invention, la matrice d'éléments-mémoire, constituée sur un substrat dont la surface supérieure comporte une couche isolante, comprend une première couche métallique conductrice gravée définissant des lignes d'accès aux éléments-

2

mémoire, et une deuxième couche métallique conductrice (sur un autre niveau pour qu'il n'y ait pas de connexion directe entre les deux couches), la deuxième couche étant gravée pour définir des colonnes d'accès aux éléments-mémoire. Entre les couches métalliques, au niveau des zones de croisement entre une ligne et une colonne, est prévue une couche de silicium polycristallin découpée selon des portions correspondant à chaque zone de croisement donc à chaque point mémoire, cette couche de silicium polycristallin étant en contact par sa surface inférieure avec la première couche métallique et par sa surface supérieure avec la deuxième couche métallique. La couche de silicium polycristallin est faiblement dopée dans sa surface en contact avec l'une des couches métalliques de manière à réaliser un contact Schottky ; dans sa surface en contact avec l'autre couche, elle est faiblement dopée pour certains éléments mémoire et fortement dopée pour d'autres, de manière que les états logiques possibles du point mémoire soient définis par l'existence d'un contact Schottky ou d'un contact ohmique entre le silicium polycristallin et ladite autre couche métallique.

Le procédé de fabrication selon l'invention nécessite, après dépôt et gravure de la première couche métallique et d'une couche de silicium polycristallin peu dopée, un masquage des zones de silicium polycristallin correspondant aux éléments mémoire devant représenter le premier état logique, et un dopage superficiel, par exemple par implantation ionique, des zones de silicium polycristallin non masquées, qui sont celles correspondant aux éléments-mémoire devant représenter le deuxième état logique.

Le masquage peut être fait après dépôt et gravure de la deuxième couche métallique, à condition d'effectuer le dopage superficiel du silicium polycristallin par implantation à travers cette deuxième couche métallique qui recouvre le silicium polycristallin.

D'autres caractéristiques et avantages de l'invention apparaîtront à la lecture de la description détaillée qui suit et qui est faite en référence aux dessins annexés dans lesquels :

- la figure 1 est une coupe transversale montrant la structure de deux points mémoire d'une même ligne du réseau,

  - la figure 2 représente le schéma équivalent électrique de ces deux points,

  - les figures 3 à 6 montrent les principales étapes du procédé de réalisation selon l'invention.

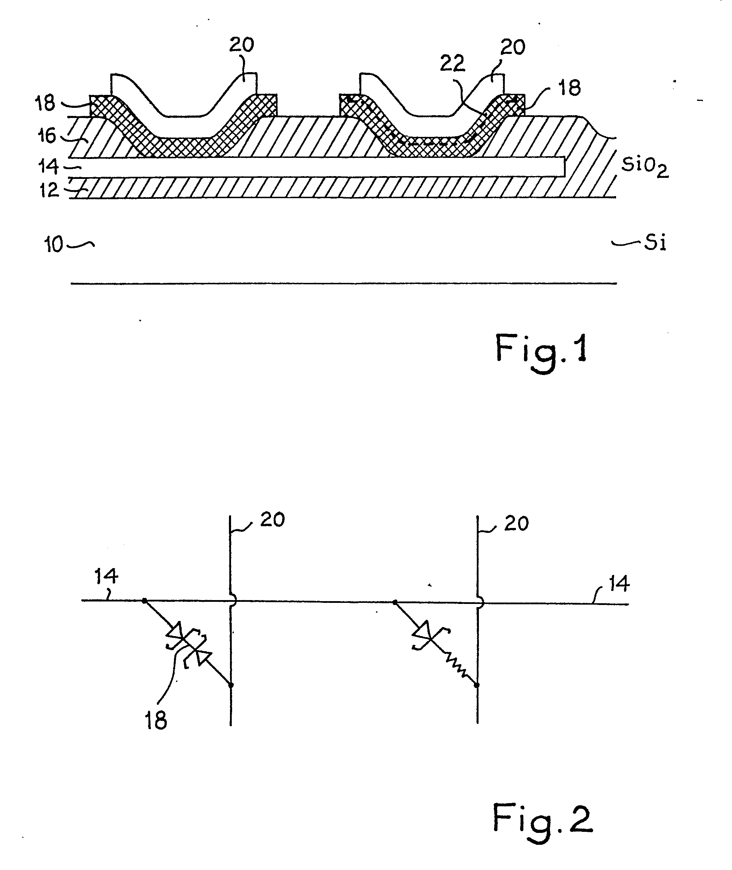

  Les deux points mémoire qui ont été représentés sur la figure 1 sont des points adjacents d'une même ligne d'accès et ils correspondent au croisement de cette ligne avec deux colonnes adjacentes ; les points mémoire représentés correspondent respectivement à un premier état logique (qu'on peut appeler état logique 0) et un deuxième état logique (état 1).

  La matrice de points mémoire est formée sur un substrat semiconducteur 10 par exemple en silicium dont la surface supérieure est constituée par une couche isolante 12 qui peut être en oxyde de silicium $SiO_2$. Cette couche isolante est présente en-dessous de la matrice mémoire, étant entendu que le circuit intégré incorporant cette mémoire comprend d'autres circuits qui ne seront pas décrits, par exemple des circuits de sélection de ligne et de colonne pour l'accès aux différents points mémoire, la couche isolante 12 n'existant pas forcément dans les zones correspondant à ces circuits.

  Au-dessus de la couche isolante 12 est prévue une première couche métallique conductrice réfractaire 14, par exemple en alliage d'aluminium, nickel et chrome, ou un composé de titane et tungstène, ou un siliciure (de molybdène par exemple).

  Cette couche 14 est gravée selon un motif constituant un réseau de lignes parallèles. Chaque ligne se présente sous forme d'une bande étroite uniforme, ou bien de tronçons de bande reliant des plages élargies réparties le long de la ligne pour constituer les points-mémoire correspondant à cette ligne. Comme on le voit, la couche métallique 14 relie le point mémoire de gauche et le point mémoire de droite de la figure 1.

  La couche métallique 14 est recouverte d'une autre couche isolante 16 qui peut être de l'oxyde de silicium protégeant la couche 14. Cette couche a une épaisseur qui peut être de l'ordre de 5000 angströms. Elle est gravée de manière à présenter une

4

ouverture au niveau de chaque point mémoire, c'est-à-dire de chaque croisement entre une ligne et une colonne du réseau. Cette ouverture a par exemple des côtés de quelques microns et elle est localisée au-dessus d'une portion de couche métallique 14 sans en déborder.

Les ouvertures dans l'oxyde 16 sont remplies par des portions d'une couche de silicium polycristallin 18 qui recouvre toute la surface de couche métallique 14 non recouverte d'oxyde 16 et qui peut remonter sur les bords (de préférence biseautés) de la couche d'oxyde 16. Chaque portion de silicium polycristallin correspond à un point mémoire, mais, bien entendu, en dehors de la matrice de points mémoire, le silicium polycristallin peut servir à la constitution des autres circuits présents sur la même pastille et notamment des circuits périphériques de la mémoire (adressage, lecture, etc.).

Enfin, une deuxième couche métallique réfractaire 20, en un alliage tel que de l'aluminium-nickel-chrome ou un composé titane-tungstène, ou un siliciure de molybdène, constitue un niveau de connexion supérieur qui est gravé de manière à constituer (dans la 20 région de la mémoire) un réseau de colonnes parallèles adjacentes, perpendiculaires aux lignes de la couche 14 ; ces colonnes conductrices se présentent sous forme de bandes uniformes coupant les lignes aux endroits où les portions de couche de silicium polycristallin 18 recouvrent ces lignes, ou bien sous forme de 25 tronçons de bandes reliant des plages conductrices élargies recouvrant les portions de silicium polycristallin 18. Le métal de la couche 20 est directement en contact avec le silicium polycristallin.

La couche 20 peut servir bien entendu à d'autres interconnexions en dehors du réseau de points mémoire proprement dit.

Le silicium polycristallin est essentiellement du silicium polycristallin haute résistivité, c'est-à-dire faiblement dopé (résistivité de l'ordre de 1000 ohms-cm au moins), au moins sur sa face en contact avec l'une des couches métalliques (ici la couche inférieure 14).

On est donc en présence d'un contact Schottky (métal- semiconducteur peu dopé) qui se comporte comme une diode dont l'anode est le métal et la cathode le silicium.

L'autre face du silicium polycristallin, en contact avec l'autre couche métallique (ici la couche 20), est faiblement dopée pour un point-mémoire représentant un état logique zéro (point-mémoire de gauche sur la figure 1), de sorte qu'il apparaît un autre contact Schottky entre la couche 20 et le silicium polycristallin. On a donc entre le conducteur de ligne 14 et le conducteur de colonne 20, deux contacts Schottky successifs constituant deux diodes Schottky en série tête-bêche comme le montre le schéma équivalent électrique de la partie gauche de la figure 2. La cathode commune des deux diodes Schottky est constituée par la couche de silicium polycristallin.

Au contraire, pour réaliser un point mémoire dans l'état logique 1, on prévoit que l'autre face (ici la face supérieure) du silicium polycristallin, en contact avec la couche métallique 20 est plus fortement dopée que la première face, et, plus précisément, qu'elle est suffisamment dopée pour constituer un contact ohmique entre la couche 20 et le silicium.

La résistivité de la partie supérieure (zone 22 sur la figure 1) peut être d'environ 0,1 ohms-cm ou moins.

On aboutit, pour un point mémoire d'état logique 1, au schéma électrique équivalent de la partie droite de la figure 2 comportant une diode Schottky entre le conducteur de ligne 14 et le silicium polycristallin et une résistance, essentiellement due à la résistivité de la partie inférieure (en-dessous de la zone 22) du silicium polycristallin, entre la diode Schottky et le conducteur de colonne 20.

Si on sélectionne une ligne de points-mémoire donnée et qu'on lui applique une tension positive de quelques volts (inférieure à la tension de claquage inverse des diodes Schottky), et si on relie chaque conducteur de colonne à une charge résistive elle-même reliée à un potentiel de référence nul (cette charge étant pratiquement au moins aussi résistive que la résistance due au silicium polycristallin), le potentiel apparaissant sur une colonne 20 restera à zéro pour un point mémoire dans l'état logi-

6

que zéro et passera à quelques volts pour un point mémoire dans l'état logique 1. La distinction entre les deux états peut d'ailleurs se faire différemment, par exemple par comparaison du courant passant dans une colonne sélectionnée et du courant dans une colonne de référence dont tous les points mémopire sont dans l'état logique 1.

Le réseau de points-mémoire ainsi réalisé peut être très dense car chaque point mémoire ne nécessite pratiquement que l'espace nécessaire à la constitution d'un contact Schottky ; la structure du point mémoire est en effet une simple superposition verticale de couches sans aucun motif de dessin latéral comme c'est le cas dans des points mémoire utilisant des transistors, ceux-ci devant par exemple comporter au moins un drain et une source séparés pour des transistors MOS. On peut donc ici arriver à une densité de points mémoire correspondant pratiquement à la densité de lignes et de colonnes que l'on peut graver côte à côte en tenant compte de la nécessité d'aligner sur les points de croisement les zones de silicium polycristallin 18.

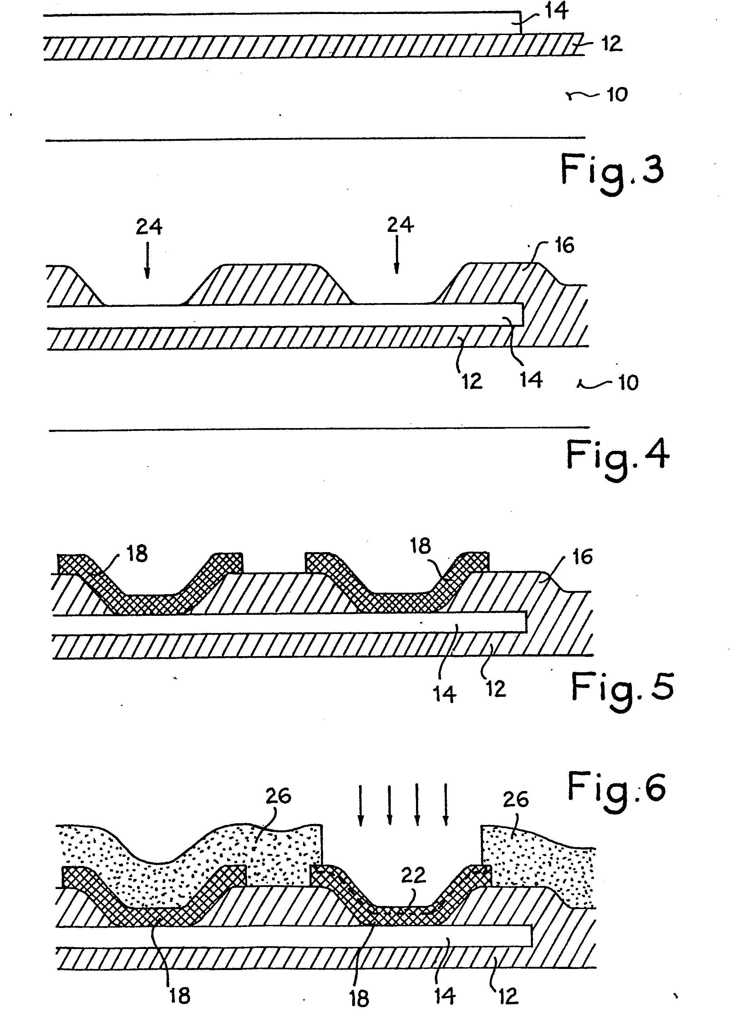

Outre ce faible encombrement, la matrice selon l'invention présente l'avantage d'une grande simplicité de fabrication et on va maintenant donner les grandes lignes du procédé permettant de la réaliser, en référence aux figures 3 à 6.

On part du substrat 10 recouvert d'une couche isolante 12 qui peut être constituée par de l'oxyde épais servant à l'isolation de transistors par rapport aux interconnexions dans les circuits périphériques de la mémoire. Ce substrat de départ recouvert de la couche isolante 12 peut très bien comporter déjà des éléments de circuit (notamment des transistors formés par des régions complémentaires de type N et P diffusées dans le substrat), mais seulement en dehors de la matrice de points-mémoire ; c'est pourquoi ces éléments n'apparaissent pas sur la figure 3.

On dépose une première couche métallique réfractaire 14 que l'on grave selon un motif de lignes désiré avec éventuellement des plages élargies au niveau de chaque point mémoire (figure 3).

On dépose ensuite une couche isolante 16, par exemple de l'oxyde de silicium pyrolytique, que l'on grave aux emplacements prévus pour les croisements de lignes et de colonnes de la matrice mémoire pour mettre à nu le métal à ces emplacements 24 (figure 4).

On dépose alors une couche de silicium polycristallin de haute résistivité, par exemple par décomposition de silane à basse pression et on grave cette couche pour laisser subsister, sur la surface de la matrice mémoire, seulement des portions 18 de silicium, séparées les unes des autres, ces portions recouvrant complètement les ouvertures 24 ménagées aux points de croisement des lignes et colonnes (figure 5).

Deux solutions sont alors possibles pour continuer le procédé.

La plus simple (figure 6) consiste à masquer par une couche de résine 26 les portions de silicium polycristallin correspondant aux points mémoire représentant l'état logique 0, à dénuder les autres et à effectuer un dopage superficiel du silicium polycristallin, par exemple par implantation de bore, de manière à créer la couche superficielle plus dopée 22 mentionnée en référence à la figure 1, sans augmenter le dopage de la partie inférieure du silicium polycristallin.

Après cela, on élimine la résine, on dépose une deuxième couche métallique 20 que l'on grave selon un motif de colonnes perpendiculaires aux lignes de la couche 14, les colonnes croisant les lignes à l'emplacement des portions de silicium polycristallin 18. Le procédé se termine par un recuit, une passivation et une ouverture de contacts de plots de thermocompression. Le recuit réalise un contact ohmique entre la deuxième couche 20 et les zones implantées 22.

Une autre solution est possible, plus difficile à mettre en oeuvre, mais ayant l'avantage de permettre une programmation de la mémoire (c'est-à-dire une attribution d'états logiques 0 ou 1 aux différents points mémoire) plus tardive dans le procédé de fabrication. Cette solution consiste, après l'étape de la figure 5, à effectuer tout de suite le dépôt et éventuellement la gravure de la deuxième couche métallique 20, et à effectuer seulement

8

ensuite le masquage par de la résine (comme à la figure 6) des zones correspondant aux points mémoire d'état logique 0, puis l'implantation, à travers la couche métallique 20 déjà en place, d'ions susceptible de doper suffisamment la surface supérieure du silicium polycristallin dans les emplacements non protégés par la résine.

Cette manière de procéder impose que l'épaisseur de la deuxième couche métallique 20 ne soit pas trop importante (elle peut être de l'ordre de 3 à 4000 angströms) et que l'implantation (de bore) soit faite avec une énergie relativement forte (de l'ordre de 200 keV).

Comme il s'agit d'une mémoire morte susceptible seulement d'être lue, les courants passant dans les connexions de lignes et de colonnes peuvent être toujours très réduits de sorte qu'il n'est pas gênant de prévoir que les métallisations de colonnes sont peu épaisses.

On peut concevoir des variantes de procédé de fabrication sans sortir du cadre de l'invention, par exemple en supprimant le dépôt et la gravure de l'oxyde de silicium 16 et en effectuant directement sur le métal un dépôt de silicium polycristallin que l'on découpe en portions séparées les unes des autres par un procédé de type "LOCOS", à savoir une oxydation localisée complète de la masse du silicium polycristallin en protégeant par du nitrure, pendant cette oxydation, les zones de silicium à conserver.

REVENDICATIONS.

1. Matrice d'éléments-mémoire intégrés, constituée sur un substrat (10) dont la surface supérieure comporte une couche isolante (12), cette matrice comprenant une première couche métallique conductrice gravée (14) définissant des lignes d'accès aux éléments-mémoire et une deuxième couche métallique conductrice gravée (20) définissant des colonnes d'accès aux éléments-mémoire, caractérisée par le fait qu'elle comprend, entre les couches métalliques, au niveau des zones de croisement entre une ligne et une colonne d'accès, une couche de silicium polycristallin (18) découpée selon des portions correspondant à chaque zone de croisement, cette couche étant en contact à sa partie inférieure avec la première couche métallique et à sa partie supérieure avec la seconde, la couche de silicium polycristallin étant faiblement dopée dans sa partie en contact avec l'une des couches métalliques de manière à réaliser un contact Schottky, et étant faiblement dopée pour des éléments-mémoire dans un premier état, et fortement dopée pour des éléments-mémoire dans un deuxième état, dans sa partie en contact avec l'autre couche métallique, de manière que la couche de silicium polycristallin constitue avec ladite autre couche métallique un contact Schottky pour certains éléments et un contact ohmique pour d'autres.

2. Procédé de réalisation d'une matrice intégrée d'éléments-mémoire sur un substrat (10) dont la surface supérieure est constituée par une couche isolante (12), caractérisé par les opérations consistant à :

a) déposer sur le substrat une première couche métallique conductrice (14) et la graver pour former des lignes d'accès à des éléments-mémoire et des zones d'éléments-mémoire reliées par ces lignes,

b) déposer une couche de silicium polycristallin peu dopée (18) et la découper selon un motif de zones séparées correspondant chacune à une zone d'élément mémoire, le silicium polycristallin étant en contact avec la première couche métallique (14) dans ces zones,

c) masquer le silicium polycristallin dans des régions où les éléments-mémoire doivent correspondre à un premier état logique et le laisser à nu dans des régions où les éléments-mémoire doivent correspondre à un second état, doper superficiellement le silicium polycristallin dans les régions non masquées en conservant un faible dopage du silicium polycristallin dans sa partie en contact avec la première couche métallique et dans les régions masquées,

d) déposer et graver une deuxième couche métallique conductrice (20) pour définir des colonnes d'accès aux éléments-mémoire, des régions de la deuxième couche métallique étant en contact avec la surface supérieure du silicium polycristallin dans les zones d'éléments-mémoire.

3. Procédé selon la revendication 2, caractérisé par le fait que le dépôt et éventuellement la gravure de la deuxième couche métallique sont effectués avant le masquage et le dopage du silicium polycristallin, l'épaisseur de la deuxième couche métallique étant suffisamment faible pour permettre un dopage superficiel du silicium polycristallin par implantation à travers la deuxième couche métallique.

4. Procédé selon l'une des revendications 1 et 2, caractérisé par le fait qu'avant le dépôt de la couche de silicium polycristallin, on dépose une couche isolante (16) et on la grave pour définir des ouvertures dans lesquelles la couche de silicium polycristallin sera en contact avec la première couche métallique.

Fig.1

Fig.2

2/2

14

12

~ 10

**Fig.3**

24          24          16

12    14    ~ 10

**Fig.4**

18          18          16

14    12    **Fig.5**

26          26    **Fig.6**

22

18          18    14    12